# FASCICULE DE BREVET EUROPEEN

(11) **EP 3 035 129 B1**
(45) Date de publication et mention de la délivrance du brevet: **04.11.2020**
(21) Numéro de dépôt: 14199479.8
(22) Date de dépôt: 19.12.2014
(51) Int. Cl.: G04B 45/00

(54) **Procede de realisation d'un element decore d'une piece d'horlogerie ou de bijouterie**
Herstellungsverfahren eines Dekorelements für eine Uhr oder ein Schmuckstück
Method for producing a decorated element of a timepiece or piece of jewellery

(43) Date de publication de la demande: 22.06.2016
(73) Titulaire: The Swatch Group Research and Development Ltd, 2074 Marin (CH)
(72) Inventeur: Dubach, Alban, 2502 Bienne (CH); Vuille, Pierry, 2207 Coffrane (CH); Winkler, Yves, 3185 Schmitten (CH); Bourban, Stewes, 1589 Chabrey (CH); Martin, Jean-Claude, 2037 Montmollin (CH)
(74) Mandataire: Goulette, Ludivine

(56) Documents cités:
- EP-A1- 2 316 299
- US-A1- 2011 203 934
- US-A1- 2011 303 546

## Description

L'invention concerne un procédé de réalisation d'au moins un élément décoré d'une pièce d'horlogerie ou de bijouterie.

L'invention concerne également l'élément décoré obtenu selon le procédé de réalisation.

Pour décorer un élément ou composant d'une pièce d'horlogerie ou de bijouterie, il peut être effectué un émaillage sur une surface du composant après avoir réalisé notamment un ensemble de cloisons sur le composant. Il peut s'agir d'un émaillage à chaud. Cette technique traditionnelle dite cloisonnée fait partie des nombreuses techniques d'émaillage, qui comprennent entre autre la grisaille, l'appliqué à sec, la peinture sur émail, le champlevé, la basse taille, le plique à jour, l'émail en relief, le paillonné pour en citer les principales.

Le principe de cette technique artisanale de décoration consiste à créer manuellement un motif constitué de cloisons en fil métallique, puis de le remplir de couches successives d'émaux de différentes couleurs, transparents ou opaques sur un support métallique ou céramique. Les matières premières de la substance vitreuse dite émail, sont principalement la silice sous forme de sable très pur, les feldspaths, les pegmatites, la craie, la chaux, et, parfois, des kaolins, associés à des composants métalliques pour lui donner sa couleur. Cette substance déposée sur une surface du composant, est cuite jusqu'à sa fusion et adhérence sur le composant métallique ou céramique. La réalisation du décor par diverses étapes manuelles est longue et ne peut être reproduite de manière identique d'un composant à l'autre, ce qui constitue un inconvénient.

Dans le cas de la technique du cloisonné, il doit être compté généralement un nombre important d'étapes de réalisation de l'élément décoré. Cela passe par la réalisation du dessin du motif directement sur papier ou ordinateur avant une fabrication à la main des motifs du décor avec notamment un fil métallique posé sur le dessin comme base. Une reproduction du dessin sur un support métallique ou céramique ou céramo-métallique est réalisée notamment par gravure main, gravure machine ou à main levée. Le support peut ensuite être émaillé avec une couche d'émail transparent ou non. Les motifs du décor sont encore placés et fixés sur le support pour former les cloisons, qui sont mises à niveau. Un matériau de remplissage, tel que l'émail est par la suite inséré dans les cloisons et normalement une cuisson du support émaillé doit encore être effectuée. Une opération de polissage peut encore être prévue lorsque le composant émaillé est sorti du four. Comme un très grand nombre d'étapes est prévu pour ce procédé de réalisation d'un élément décoré, cela constitue un inconvénient de réalisation d'un tel élément décoré.

On peut citer à ce titre le brevet EP 2 380 864 B1, qui décrit un procédé de fabrication d'un élément céramique, qui est incrusté d'au moins un décor métallique. Il est effectué tout d'abord une gravure dans le matériau céramique au moyen d'un faisceau laser pour obtenir une ou plusieurs creusures. Après cela, il est effectué un dépôt dans chaque creusure, d'une couche métallique par dépôt en phase vapeur et autocatalyse chimique en tant que couche d'accrochage. Par la suite, une couche de décoration est déposée de manière galvanique sur la couche d'accrochage pour finaliser le décor de d'élément. Il est compliqué de remplir chaque creusure réalisée dans le matériau céramique avec les couches métalliques pour réaliser l'élément décoré, ce qui constitue un inconvénient. De plus, une décoration uniquement par dépôt d'une couche métallique en phase vapeur ne permet pas d'obtenir des couches décoratives d'une épaisseur suffisante.

Dans la demande de brevet CH 707 533 A2, il est décrit un procédé de fabrication d'un cadran de montre décoré avec une broderie. Il est effectué tout d'abord une gravure par décalque dans un canevas en tissu. Une fois le calque percé selon le motif souhaité, une poudre est étalée sur le calque. Une impression du motif sur le canevas est ensuite effectuée pour mettre en évidence le motif pour l'opération de broderie, qui suit cette étape d'impression. Une fois la broderie terminée, le canevas décoré est collé sur un support, tel qu'un cadran de montre. Ce procédé comporte également un très grand nombre d'étapes pour décorer le cadran de montre, ce qui est un inconvénient. De plus, il ne peut pas être réalisé une décoration de forme complexe avec ce procédé et le collage du décor n'est en général pas fiable à long terme.

Les demandes de brevet US 2011/0203934 A1 et US 2011/0303546 A1 décrivent un procédé de fabrication de microstructures métalliques. Pour obtenir ces microstructures métalliques, il est utilisé un procédé du type LIGA hétérogène. Tout d'abord, une couche d'amorçage métallique doit être déposée sur un substrat de base, et une structuration d'une couche de résine photosensible par photolithographie est effectuée. Une croissance galvanique sur la couche d'amorçage métallique est ensuite effectuée pour obtenir un motif métallique dans des portions retirées de la couche de résine. La couche de résine est finalement retirée tout comme le substrat de base pour obtenir ladite microstructure métallique. Comme la microstructure métallique est obtenue par une technique LIGA avec croissance galvanique, cela ne permet d'effectuer rapidement et facilement un élément décoré, ce qui est un inconvénient.

La demande de brevet EP 2 316 299 A1 décrit une pièce d'horlogerie ou de bijouterie et son procédé de fabrication. La pièce comprend une structure de base en métal, qui est munie d'un décor en relief, et d'une couche en élastomère déposée sur une surface de la structure par l'intermédiaire d'une couche d'adhésion. Le motif du décor est obtenu par fraisage ou attaque chimique ou laser ou étampage, mais ne permet pas d'obtenir rapidement et facilement un décor précis et de forme complexe, ce qui constitue un inconvénient.

L'invention a donc pour but de proposer un procédé de réalisation d'un élément décoré d'une pièce d'horlogerie ou de bijouterie en palliant les inconvénients de l'état de la technique susmentionné pour faciliter la fabrication d'un tel élément décoré et sa reproductibilité.

A cet effet, l'invention concerne un procédé de réalisation d'un élément décoré d'une pièce d'horlogerie ou de bijouterie, qui comprend les caractéristiques mentionnées dans les revendications indépendantes 1 à 3.

Des étapes particulières du procédé de réalisation d'un élément décoré sont définies dans les revendications dépendantes 4 à 15.

Un avantage du procédé de réalisation d'un élément décoré réside dans le fait qu'il est possible de réaliser facilement des décors bidimensionnels ou tridimensionnels avec des formes complexes avec un nombre restreint d'étapes de réalisation. Les décors peuvent être fabriqués directement sur un objet métallique, céramique ou céramo-métallique, tel que cermet, et de manière industrielle. Pour améliorer l'adhérence avec le décor, le substrat de base peut être traité d'une couche métallique ou céramique ou cermet de la même famille que les matériaux du décor. Préalablement, les décors sont dessinés ou programmés sur un ordinateur, ce qui permet de réaliser des décors très fins et reproductibles.

Un avantage du procédé de réalisation de l'élément décoré réside dans le fait, qu'il peut être obtenu les cloisons ou moule sur un substrat de base par un dépôt d'une pâte ou poudre à braser dans des portions de résine ouvertes sur le substrat et selon le motif du décor dessiné. La pâte ou poudre à braser peut être déposée soit directement en surface du substrat de base, qui peut être métallique ou céramique, ou sur une couche conductrice réalisée en surface du substrat de base. La pâte ou poudre à braser, insérée dans les portions ouvertes de la résine, est par la suite chauffée et fondue avant une solidification de la brasure. Toute composition métallique pour la brasure peut être utilisée en tenant compte de la couleur des composants métalliques de la montre, sur lesquels peut être placé l'élément décoré. Finalement la résine peut être facilement retirée par attaque chimique, et les cloisons, obtenues par une brasure à bas point de fusion, sont remplies d'un matériau de remplissage pour le décor.

Avantageusement, le matériau de remplissage peut être un émail à froid, défini comme faux émail. Pour cette technique d'émaillage à froid, il est utilisé une résine époxy, qui est un polymère thermodurcissable muni de pigments de couleur. Une fois insérée dans les cloisons, la résine époxy est séchée. Pour le matériau de remplissage, il peut s'agir également de poudres céramiques ou céramo-métalliques, dont le point de fusion doit être inférieur à celui du matériau utilisé pour réaliser les cloisons.

Les buts, avantages et caractéristiques du procédé de réalisation d'un élément décoré d'une pièce d'horlogerie ou de bijouterie, ainsi que l'élément décoré obtenu apparaîtront mieux dans la description suivante en regard des dessins sur lesquels :
les figures 1a à 1g représentent les différentes étapes de réalisation d'un élément décoré d'une pièce de montre ou de bijouterie selon l'invention,
la figure 2 représente un élément de pièce de montre ou de bijouterie avec des cloisons ou parois réalisées selon l'invention, et
la figure 3 représente un élément de pièce de montre ou de bijouterie après les étapes de remplissage et solidification du matériau de remplissage selon l'invention.

Dans la description suivante toutes les techniques de réalisation des motifs de décoration d'un élément de montre ou de bijouterie, qui sont bien connues dans l'état de la technique, ne seront relatées que de manière simplifiée. Les motifs de décoration concernent des cloisons ou moule déposés sur un substrat de base par des techniques définies comme des techniques de micro-usinage.

De préférence, l'invention concerne particulièrement l'industrialisation de certaines étapes des techniques du cloisonné et du plique à jour en volume. Avec ces deux techniques, il est possible par exemple d'émailler un motif en volume en créant préalablement des cloisons en fils ou bandes métalliques. Ces cloisons sont de préférence placées sur un substrat de base, qui peut être métallique ou céramique ou céramo-métallique, tel que cermet, ou un autre matériau indiqué ci-après.

Le procédé de réalisation d'un élément décoré pour une montre ou un bijou comprend une première étape essentielle de réalisation des cloisons ou parois ou moule sur le substrat de base par une technique de micro-usinage. Le substrat de base peut être un matériau métallique cristallin ou amorphe, une céramique, un semi-conducteur, un cermet, ou tout autre matériau. Concernant la céramique, cela concerne l'alumine, la zircone, la magnésie, le nitrure de bore, le nitrure de silicium, le carbure de silicium, le titanate d'aluminium et le nitrure d'aluminium, ou d'autres types de céramique. Il peut même être prévu d'avoir un substrat de base en quartz, en verre, en saphir, en corindon ou autre type de pierre précieuse. Le matériau du moule ou des cloisons peut être le même que celui du substrat de base.

Les motifs de décoration définis par les cloisons sont dessinés ou programmés préalablement sur ordinateur, et les données mémorisées du dessin ou motif sont transmises à la machine de micro-usinage pour la réalisation desdites cloisons. Par la suite, il est encore effectué une opération pour remplir les cloisons d'un matériau de remplissage, qui peut être de préférence un émail à froid, qui est un polymère thermodurcissable muni de pigments de couleur, un alliage métallique, voire une céramique ou un cermet. L'émail peut être déposé ou fixé à froid dans les cloisons et est défini comme un faux émail.

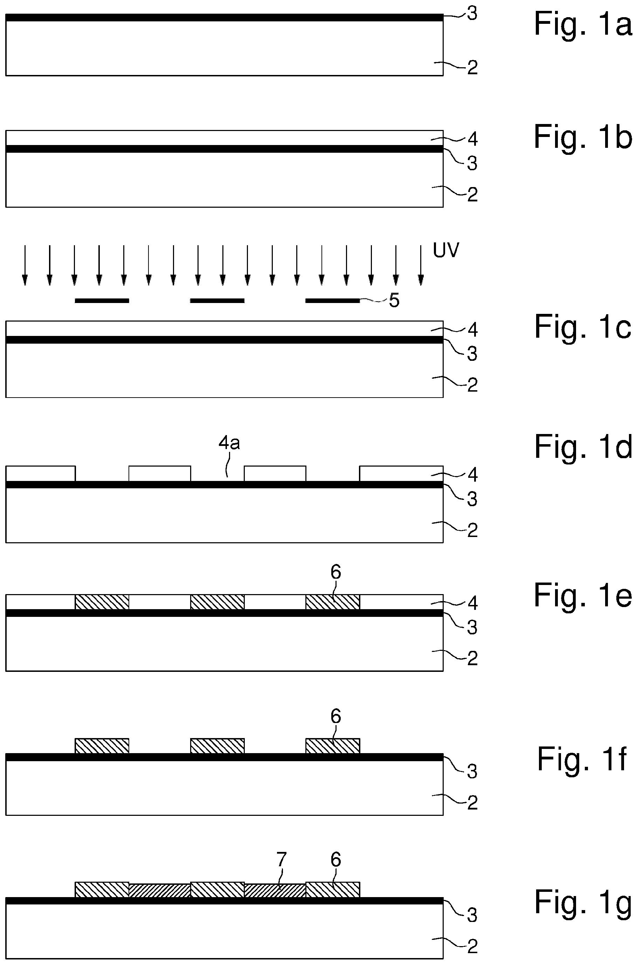

Aux figures 1a à 1g, il est décrit schématiquement toutes les étapes nécessaires pour la réalisation du décor sur un substrat de base 2 pour obtenir un élément décoré pour une pièce d'horlogerie ou de bijouterie. Pour ce faire, on se munit tout d'abord d'un substrat de base 2, qui peut être métallique, céramique ou céramo-métallique. Il peut être envisagé également d'avoir un substrat de base semi-conducteur, tel que du silicium, voire de l'arséniure de gallium.

Dans la première étape représentée à la figure 1a, au moins une couche conductrice 3 est déposée en surface du substrat de base 2. Cette couche conductrice 3 peut être une couche métallique mince déposée par une technique PVD ou CVD ou par pulvérisation cathodique. Il peut même être prévu de déposer plusieurs couches successives conductrices 3 du même matériau ou d'un matériau différent d'une couche à l'autre. Cependant cette première étape peut être évitée, si le substrat de base 2 est métallique, typiquement en cuivre, ou s'il est utilisé comme expliqué ci-après une brasure active.

Dans la seconde étape représentée à la figure 1b, une résine photosensible 4 est déposée en surface du substrat de base 2 ou sur la couche conductrice 3. Cette résine photosensible 4 peut être une résine à base de poly-imide PMMA (poly-méthyle méthacrylate) ou une résine à base d'époxy octofonctionnelle disponible chez Shell Chemical sous la référence SU-8 et d'un photo-initiateur choisi parmi les sels de triarylsulfonium. Cette résine photosensible 4 peut être photo-polymérisée au moyen d'un rayonnement ultra-violet (UV).

Dans la troisième étape représentée à la figure 1c, un masque 5 au contour du motif à réaliser sur le substrat de base 2 de l'élément est disposé sur la résine 4. Le masque 5 peut être une plaque de verre sur laquelle est réalisée une couche de masquage avec des parties opaques et transparentes selon le motif à réaliser. Un rayonnement lumineux par exemple du type ultra-violet UV est dirigé sur le masque 5 pour irradier des parties de la résine 4 non masquées. Avec ce type de résine 4 utilisée, qui est une résine photosensible négative, les parties non irradiées peuvent être retirées à la quatrième étape représentée à la figure 1d, par des moyens physiques ou chimiques. Cela permet de définir les formes des cloisons ou moule dans les parties retirées 4a de la résine 4.

Il est à noter qu'il peut aussi être utilisé une résine photosensible positive 4 avec un masque 5 à couche de masquage ayant des parties opaques et transparentes selon le motif à réaliser. Ce masque 5 est l'inverse du masque utilisé avec la résine négative 4. Dans ce cas, ce sont les parties irradiées de la résine, qui sont retirées à la quatrième étape.

Dans la cinquième étape représentée à la figure 1e, les portions ouvertes 4a de la résine 4 sur le substrat de base 2 ou sur la couche conductrice 3, sont remplies d'une pâte ou poudre à braser 6. La pâte ou poudre à braser 6 est généralement composée d'un métal ou d'un alliage métallique, qui de préférence a un point de fusion inférieur à celui de la résine photosensible, c'est-à-dire en dessous de 380°C. La pâte à braser 6 est composée généralement d'une poudre avec un additif ou liant organique. La poudre métallique utilisée peut être par exemple un mélange d'or et d'étain (Au-Sn) ou il peut y avoir un mélange de deux poudres, qui sont l'or et l'étain de la première poudre et l'or pour la seconde poudre. La pâte ou poudre à braser à basse température de fusion, peut également être constituée de compositions eutectiques Au-Si à point de fusion vers 363°C, Au-Ge à point de fusion vers 361 °C, Au-Sb à point de fusion vers 360°C ou des alliages Au-Ga à point de fusion vers 340°C et Au-Ga-In à point de fusion vers 325°C. De plus, d'autres types de compositions de brasure tendre sans élément précieux peuvent être utilisés et qui sont à base de Sn, Sn-Pb ou In à point de fusion inférieur à 380°C.

Il peut également être envisagé d'avoir une pâte ou poudre à braser 6, qui est composée d'un mélange de poudre métallique et de particules céramiques. La poudre métallique est la partie du mélange, qui peut facilement fondre et lier également les particules céramiques. Ce type de mélange a l'avantage d'augmenter la dureté des cloisons réalisées tout en donnant un aspect composite.

Dans la sixième étape représentée également à la figure 1e, l'ensemble, qui est composé notamment du substrat de base 2, de la résine 4 et de la pâte ou poudre à braser 6 insérée dans les portions ouvertes 4a de la résine 4, est chauffé de manière à faire fondre la pâte ou poudre à braser 6 dans les cloisons. Après cela, une solidification de la pâte ou poudre à braser intervient. Grâce à l'effet de capillarité de la brasure liquide dans les cloisons, il y a une bonne accroche de ladite brasure basse température pour compléter entièrement tous les espaces dans les cloisons. Dans le cas de la pâte à braser métallique, le ou les additifs organiques sont brûlés ou évaporés.

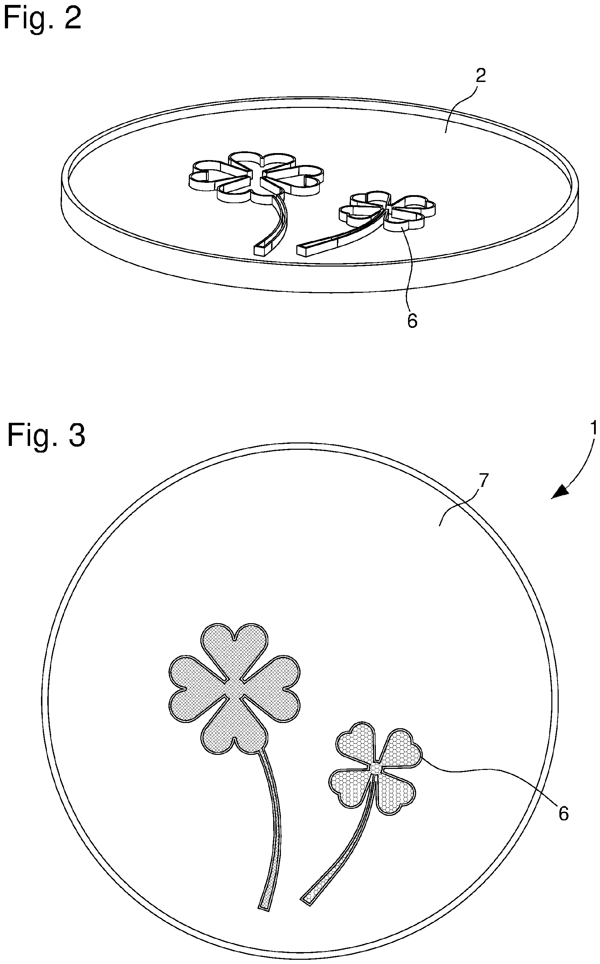

Dans la septième étape représentée à la figure 1f, toute la résine photosensible 4 est retirée. Après cette étape de retrait de la résine, on obtient un élément avec les cloisons métalliques 6 réalisées. Cet élément est représenté par exemple sous forme de cadran de montre en vue tridimensionnelle avec son motif à la figure 2.

Dans la huitième étape représentée à la figure 1g, les espaces entre les cloisons 6 sont remplis par un matériau de remplissage 7, qui peut être de préférence un émail à froid ou faux émail, tel qu'une résine époxy avec pigments de couleur. Différentes couleurs du matériau de remplissage 7 peuvent être choisies pour garnir les cloisons 6, afin de réaliser un élément décoré. Ce faux émail est séché pour être solidifié et ainsi former un élément décoré 1 au terme du procédé de réalisation.

Un autre type de matériau de remplissage 7, tel qu'un métal ou alliage métallique, peut être inséré sous forme pâteuse ou liquide dans les espaces entre les cloisons avant d'être solidifié. Il peut être envisagé d'utiliser comme matériau de remplissage de la céramique ou du cermet, qui est disposé entre les cloisons sous forme de poudre ou de liquide avant une opération de solidification. Une fois terminé, l'élément décoré 1 peut se présenter sous forme de cadran de montre comme représenté de dessus à la figure 3.

Bien entendu, il peut encore être prévu après la huitième étape de supprimer le substrat de base 2, par exemple en métal ou en céramique ou céramo-métallique, voire également en matériau semi-conducteur par une opération d'usinage ou de dissolution sélective. Dans ce cas, l'élément décoré 1 obtenu comprend donc des portions d'émail en résine époxy 7 entourées de la structure 6 de motif.

Il est encore à noter que le substrat de base 2 peut encore être creusé notamment par faisceau laser pour améliorer l'accroche mécanique du matériau de remplissage 7 entre les cloisons. Il peut aussi être prévu de pratiquer des micro-perçages ou creusures dans les cloisons réalisées pour assurer un bon maintien du matériau de remplissage 7. Ces opérations sont effectuées avant d'insérer la pâte ou poudre à braser dans les portions ouvertes de la résine. Différentes épaisseurs du matériau de remplissage 7 peuvent être envisagées pour obtenir un motif de décor bidimensionnel ou tridimensionnel.

Dans une variante de réalisation, il peut être envisagé à la cinquième étape du procédé de déposer une ou plusieurs couches PVD ou galvaniques métalliques dans les portions ouvertes 4a de la résine 4. Cette résine peut par la suite être retirée et une pâte ou poudre à braser 6 est déposée sur la ou les couches conductrices PVD ou galvaniques déposées sur le substrat de base 2. Une fusion de la pâte ou poudre à braser 6 est effectuée au-dessus des couches conductrices réalisée selon le motif du décor. Comme la brasure liquide ne mouille que les zones métallisées et non pas le substrat de base 2, qui est dans ce cas en céramique, les cloisons sont réalisées après solidification de la pâte ou poudre à braser selon le motif désiré et avec une épaisseur adéquate. Par la suite, le matériau de remplissage 7 est inséré dans les cloisons et les mêmes opérations sont effectuées comme susmentionné pour réaliser l'élément décoré 1.

Il est à noter que dans la variante de réalisation susmentionnée, la pâte ou poudre à braser n'a plus besoin d'être à bas point de fusion étant donné que la résine a été retirée. Le point de fusion de la pâte ou poudre à braser doit par contre être inférieur au point de fusion du substrat de base sur lequel elle est disposée avant chauffage.

Bien entendu pour cette variante de réalisation, il peut aussi être envisagé d'avoir un substrat de base métallique, mais dans ce cas, il est nécessaire de déposer au moins une couche non-métallique par PVD ou CVD, tel qu'un oxyde ou nitrure autour du motif du décor, où doit être déposée la pâte ou poudre métallique à braser. Il n'est également pas déposé d'autres couches conductrices par PVD ou CVD, comme le substrat de base est métallique. Pour ce faire suite au dépôt de la résine photosensible sur le substrat de base, cette résine est irradiée par un faisceau UV à travers un masque du motif à réaliser. Les parties non irradiées de la résine par exemple sont retirées, afin de réaliser le dépôt de la ou des couches non métalliques pour définir un motif complémentaire pour la réalisation des cloisons ou moule. Une fois que la ou les couches non métalliques sont déposées, toute la résine peut être retirée. Dès cet instant la pâte ou poudre à braser est déposée dans des portions retirées de la ou des couches non conductrices. La brasure est fondue et solidifiée pour réaliser les cloisons ou le moule. Finalement le matériau de remplissage peut garnir les espaces entre les cloisons pour obtenir l'élément décoré.

A partir de la description qui vient d'être faite, plusieurs variantes du procédé de réalisation d'un élément décoré d'une pièce d'horlogerie ou de bijouterie peuvent être conçues par l'homme du métier sans sortir du cadre de l'invention définie par les revendications. L'élément décoré peut être également une aiguille de montre, ou un disque de quantième, un autre composant de la montre, tel qu'une roue des secondes, une masse oscillante, un fond de boîte de montre.

## Revendications

1. Procédé de réalisation d'un élément décoré (1) d'une pièce d'horlogerie ou de bijouterie, le procédé comprenant les étapes de :
- se munir d'un substrat de base (2),
- déposer sur le substrat de base (2) une couche de résine photosensible (4) de type positif ou négatif,
- placer sur la résine photosensible (4) un masque (5) au contour du motif à réaliser,
- illuminer la résine (4) à travers le masque (5),
- retirer les parties illuminées de la résine (4), si la résine photosensible est du type positif, ou retirer les parties non illuminées de la résine (4), si la résine photosensible est du type négatif,
- remplir les portions retirées (4a) de la résine (4) avec au moins une pâte ou poudre à braser (6) pour réaliser les cloisons ou le moule,
- chauffer l'ensemble composé du substrat de base (2), de la résine (4) et de la pâte ou poudre à braser (6) pour fondre la pâte ou poudre à braser (6) avant solidification de la brasure,
- retirer toute la résine (4), et
- remplir le moule ou les cloisons décoratives (6) d'au moins un matériau de remplissage (7) pour obtenir l'élément décoré (1).

2. Procédé de réalisation d'un élément décoré (1) d'une pièce d'horlogerie ou de bijouterie, le procédé comprenant les étapes de :
- se munir d'un substrat de base céramique (2),
- déposer sur le substrat de base (2) une couche de résine photosensible (4) de type positif ou négatif,
- placer sur la résine photosensible (4) un masque (5) au contour du motif à réaliser,
- illuminer la résine (4) à travers le masque (5),
- retirer les parties illuminées de la résine (4), si la résine photosensible est du type positif, ou retirer les parties non illuminées de la résine (4), si la résine photosensible est du type négatif,
- déposer dans les portions retirées (4a) de la résine (4), une ou plusieurs couches métalliques par dépôt en phase vapeur physique ou chimique,
- retirer toute la résine (4),
- déposer au moins une pâte ou poudre à braser (6) sur la ou les couches métalliques,
- fondre la pâte ou poudre à braser (6), pour obtenir une brasure liquide, qui ne mouille que la ou les couches métalliques, et solidifier la brasure liquide pour réaliser les cloisons ou le moule selon le motif désiré, et
- remplir le moule ou les cloisons décoratives (6) d'au moins un matériau de remplissage (7) pour obtenir l'élément décoré (1).

3. Procédé de réalisation d'un élément décoré (1) d'une pièce d'horlogerie ou de bijouterie, le procédé comprenant les étapes de :
- se munir d'un substrat de base métallique (2),
- déposer sur le substrat de base (2) une couche de résine photosensible (4) de type positif ou négatif,
- placer sur la résine photosensible (4) un masque (5) au contour du motif à réaliser,
- illuminer la résine (4) à travers le masque (5),
- retirer les parties illuminées de la résine (4), si la résine photosensible est du type positif, ou retirer les parties non illuminées de la résine (4), si la résine photosensible est du type négatif,
- déposer dans les portions retirées (4a) de la résine (4), une ou plusieurs couches non conductrices par dépôt en phase vapeur physique ou chimique pour définir un motif complémentaire pour la réalisation des cloisons ou moule,
- retirer toute la résine (4),
- déposer au moins une pâte ou poudre à braser (6) sur le substrat de base,
- fondre et solidifier la pâte ou poudre à braser (6) pour réaliser les cloisons ou le moule entre les portions des couches non-conductrices, et
- remplir le moule ou les cloisons décoratives (6) d'au moins un matériau de remplissage (7) pour obtenir l'élément décoré (1).

4. Procédé de réalisation d'un élément décoré (1) selon l'une des revendications 1 à 3, **caractérisé en ce qu'**au moins une couche conductrice, telle qu'une couche métallique est déposée par un dépôt en phase vapeur physique ou chimique ou par pulvérisation cathodique en surface du substrat de base (2) avant de déposer la couche de résine (4).

5. Procédé de réalisation d'un élément décoré (1) selon l'une des revendications 1 à 3, **caractérisé en ce que** la pâte ou poudre à braser (6) utilisée est de la pâte ou poudre à braser métallique.

6. Procédé de réalisation d'un élément décoré (1) selon la revendication 5, **caractérisé en ce que** la pâte ou poudre à braser (6) utilisée est à bas point de fusion en dessous de 380 °C.

7. Procédé de réalisation d'un élément décoré (1) selon la revendication 6, **caractérisé en ce que** la ou les poudres métalliques (6) sont composées d'un mélange d'or et d'étain, ou un mélange d'or et d'étain pour une première poudre et d'or pour une seconde poudre.

8. Procédé de réalisation d'un élément décoré (1) selon l'une des revendications 1 à 3, **caractérisé en ce que** la pâte ou poudre à braser (6) est constituée de compositions eutectiques Au-Si ou Au-Ge ou Au-Sb ou d'alliages Au-Ga ou Au-Ga-In.

9. Procédé de réalisation d'un élément décoré (1) selon l'une des revendications 1 à 3, **caractérisé en ce que** la pâte ou poudre à braser (6) utilisée comprend un mélange de poudre métallique et de particules céramiques.

10. Procédé de réalisation d'un élément décoré (1) selon l'une des revendications 1 à 3, **caractérisé en ce que** la pâte à braser (6) est composée d'au moins une poudre métallique avec au moins un additif ou liant organique.

11. Procédé de réalisation d'un élément décoré (1) selon l'une des revendications 1 à 3, **caractérisé en ce qu'**une fois que le moule ou les cloisons décoratives (6) sont remplis par le matériau de remplissage (7) solidifié et maintenu à des parois dudit moule ou desdites cloisons, il est effectué une opération d'usinage ou de dissolution sélective pour retirer le substrat de base (2), qui est en métal ou en céramique ou céramo-métallique ou en matériau semi-conducteur.

12. Procédé de réalisation d'un élément décoré (1) selon l'une des revendications 1 à 3, **caractérisé en ce que** le substrat de base (2) est creusé en surface pour améliorer l'accroche mécanique du matériau de remplissage (7) sur la surface creusée du substrat entre les cloisons (6).

13. Procédé de réalisation d'un élément décoré (1) selon l'une des revendications 1 à 3, **caractérisé en ce que** des micro-perçages ou creusures sont pratiqués dans les cloisons ou le moule (6) pour améliorer le maintien mécanique du matériau de remplissage (7).

14. Procédé de réalisation d'un élément décoré (1) selon l'une des revendications 1 à 3, pour lequel l'élément décoré (1) est un cadran de montre, **caractérisé en ce que** le moule ou les cloisons décoratives (6) sont remplis par le matériau de remplissage (7), qui est de l'émail à froid, tel que de la résine époxy, pour obtenir l'élément décoré (1).

15. Procédé de réalisation d'un élément décoré (1) selon la revendication 14, **caractérisé en ce que** le moule ou les cloisons décoratives (6) sont remplis par le matériau de remplissage (7), qui est un polymère thermodurcissable muni de pigments de couleur, et de couleur différente d'une cloison à une autre cloison.

## Patentansprüche

1. Herstellungsverfahren eines Dekorelements (1) für eine Uhr oder ein Schmuckstück, wobei das Verfahren die folgenden Schritte umfasst:
- Bereitstellen eines Basissubstrats (2),
- Ausbilden einer lichtempfindlichen Harzschicht (4) vom positiven oder negativen Typ auf dem Basissubstrat (2),
- Platzieren einer Maske (5) mit einer Kontur des herzustellenden Musters auf dem lichtempfindlichen Harz (4),
- Belichten des Harzes (4) durch die Maske (5),
- Entfernen der belichteten Teile des Harzes (4), wenn das lichtempfindliche Harz vom positiven Typ ist, oder Entfernen der nicht belichteten Teile des Harzes (4), falls das lichtempfindliche Harz vom negativen Typ ist,
- Füllen der entfernten Abschnitte (4a) des Harzes (4) mit mindestens einer Lötpaste oder einem Lötpulver (6) zum Herstellen der Trennwände oder der Form,
- Erwärmen der Gesamtheit gebildet aus dem Basissubstrat (2), dem Harz (4) und der Lötpaste oder dem Lötpulver (6), um die Lötpaste oder das Lötpulver (6) zu schmelzen, bevor das Lötmittel erstarrt,
- Entfernen des gesamten Harzes (4) und
- Füllen der Form oder der Dekortrennwände (6) mit mindestens einem Füllmaterial (7), um das Dekorelement (1) zu erhalten.

2. Herstellungsverfahren eines Dekorelements (1) einer Uhr oder eines Schmuckstücks, wobei das Verfahren umfasst:
- Bereitstellen eines keramischen Basissubstrats (2),
- Ausbilden einer lichtempfindlichen Harzschicht (4) vom positiven oder negativen Typ auf dem Basissubstrat (2),
- Platzieren einer Maske (5) mit einer Kontur des herzustellenden Musters auf dem lichtempfindlichen Harz (4),
- Belichten des Harzes (4) durch die Maske (5),
- Entfernen der belichteten Teile des Harzes (4), wenn das lichtempfindliche Harz vom positiven Typ ist, oder Entfernen der nicht belichteten Teile des Harzes (4), wenn das lichtempfindliche Harz vom negativen Typ ist,
- Ausbilden einer oder mehrerer Metallschichten durch physikalische oder chemische Dampfphasenabscheidung in den entfernten Abschnitten (4a) des Harzes (4),
- Entfernen des gesamten Harzes (4),
- Aufbringen mindestens einer Lötpaste oder eines Lötpulvers (6) auf der einen oder den mehreren Metallschichten,
- Schmelzen der Lötpaste oder des Lötpulvers (6), um ein flüssiges Lötmittel zu erhalten, das nur die eine oder die mehreren Metallschichten benetzt, und Erstarrenlassen des flüssigen Lötmittels, um die Trennwände oder die Form entsprechend dem gewünschten Muster herzustellen, und
- Füllen der Form oder der Dekortrennwände (6) mit mindestens einem Füllmaterial (7), um das Dekorelement (1) zu erhalten.

3. Herstellungsverfahren eines Dekorelements (1) einer Uhr oder eines Schmuckstücks, wobei das Verfahren die folgenden Schritte umfasst:
- Bereitstellen eines metallischen Basissubstrats (2),
- Ausbilden einer lichtempfindlichen Harzschicht (4) vom positiven oder negativen Typ auf dem Basissubstrat (2),
- Platzieren einer Maske (5) mit einer Kontur des herzustellenden Musters auf dem lichtempfindlichen Harz (4),
- Belichten des Harzes (4) durch die Maske (5),
- Entfernen der belichteten Teile des Harzes (4), wenn das lichtempfindliche Harz vom positiven Typ ist, oder Entfernen der nicht belichteten Teile des Harzes (4), wenn das lichtempfindliche Harz vom negativen Typ ist,
- Ausbilden einer oder mehrerer nichtleitender Schichten in den entfernten Abschnitten (4a) des Harzes (4) durch physikalische oder chemische Dampfphasenabscheidung, um ein komplementäres Muster für die Herstellung der Trennwände oder der Form zu definieren,
- Entfernen des gesamten Harzes (4),
- Aufbringen mindestens einer Lötpaste oder eines Lötpulvers (6) auf dem Basissubstrat,
- Schmelzen und Erstarrenlassen der Lötpaste oder des Lötpulvers (6), um die Trennwände oder die Form zwischen den Abschnitten der nichtleitenden Schichten herzustellen, und
- Füllen der Form oder der Dekortrennwände (6) mit mindestens einem Füllmaterial (7), um das Dekorelement (1) zu erhalten.

4. Herstellungsverfahren eines Dekorelements (1) nach einem der Ansprüche 1 bis 3, **dadurch gekennzeichnet, dass** mindestens eine leitende Schicht, wie etwa eine metallische Schicht, durch physikalische oder chemische Dampfphasenabscheidung oder durch Kathodenzerstäubung auf der Oberfläche des Basissubstrats (2) ausgebildet wird, bevor die Harzschicht (4) ausgebildet wird.

5. Herstellungsverfahren eines Dekorelements (1) nach einem der Ansprüche 1 bis 3, **dadurch gekennzeichnet, dass** die verwendete Lötpaste oder das verwendete Lötpulver (6) eine metallische Lötpaste oder ein metallisches Lötpulver ist.

6. Herstellungsverfahren eines Dekorelements (1) nach Anspruch 5, **dadurch gekennzeichnet, dass** die verwendete Lötpaste oder das verwendete Lötpulver (6) einen niedrigen Schmelzpunkt unterhalb von 380 °C besitzt.

7. Herstellungsverfahren eines Dekorelements (1) nach Anspruch 6, **dadurch gekennzeichnet, dass** das oder die Metallpulver (6) aus einem Gemisch aus Gold und Zinn oder aus einem Gemisch aus Gold und Zinn für ein erstes Pulver und aus Gold für ein zweites Pulver gebildet sind.

8. Herstellungsverfahren eines Dekorelements (1) nach einem der Ansprüche 1 bis 3, **dadurch gekennzeichnet, dass** die Lötpaste oder das Lötpulver (6) aus eutektischen Verbindungen von Au-Si oder Au-Ge oder Au-Sb oder Legierungen von Au-Ga oder Au-Ga-In gebildet ist.

9. Herstellungsverfahren eines Dekorelements (1) nach einem der Ansprüche 1 bis 3, **dadurch gekennzeichnet, dass** die verwendete Lötpaste oder das verwendete Lötpulver (6) ein Gemisch aus einem Metallpulver und keramischen Partikeln enthält.

10. Herstellungsverfahren eines Dekorelements (1) nach einem der Ansprüche 1 bis 3, **dadurch gekennzeichnet, dass** die Lötpaste (6) aus mindestens einem Metallpulver mit mindestens einem organischen Additiv oder Bindemittel gebildet ist.

11. Herstellungsverfahren eines Dekorelements (1) nach einem der Ansprüche 1 bis 3, **dadurch gekennzeichnet, dass**, sobald die Form oder die Dekortrennwände (6) mit dem Füllmaterial (7) gefüllt sind, das erstarrt ist und auf Wänden der Form oder der Trennwände gehalten wird, ein Bearbeitungsvorgang oder ein selektiver Auflösungsvorgang ausgeführt wird, um das Basissubstrat (2), das ein Metall oder eine Keramik oder eine Metallkeramik oder ein Halbleitermaterial ist, zu entfernen.

12. Herstellungsverfahren eines Dekorelements (1) nach einem der Ansprüche 1 bis 3, **dadurch gekennzeichnet, dass** das Basissubstrat (2) an seiner Oberfläche Aussparungen aufweist, um die mechanische Verankerung des Füllmaterials (7) auf der ausgesparten Oberfläche des Substrats zwischen den Trennwänden (6) zu verbessern.

13. Herstellungsverfahren eines Dekorelements (1) nach einem der Ansprüche 1 bis 3, **dadurch gekennzeichnet, dass** in den Trennwänden oder in der Form (6) Mikrodurchlochungen oder Aussparungen ausgebildet sind, um den mechanischen Halt des Füllmaterials (7) zu verbessern.

14. Herstellungsverfahren eines Dekorelements (1) nach einem der Ansprüche 1 bis 3, wobei das Dekorelement (1) ein Uhren-Zifferblatt ist, **dadurch gekennzeichnet, dass** die Form oder die Dekortrennwände (6) mit dem Füllmaterial (7), das eine Kaltemaille wie etwa ein Epoxidharz ist, gefüllt werden, um das Dekorelement (1) zu erhalten.

15. Herstellungsverfahren eines Dekorelements (1) nach Anspruch 14, **dadurch gekennzeichnet, dass** die Form oder die Dekortrennwände (6) mit dem Füllmaterial (7) gefüllt werden, das ein mit Farbpigmenten versehenes wärmehärtbares Polymer ist und sich von einer Trennwand zur nächsten farblich unterscheidet.

## Claims

1. Method for producing a decorated element (1) for a timepiece or piece of jewellery, the method includes the steps of:
- taking a base substrate (2),
- depositing a layer of positive or negative photosensitive resin (4) on the base substrate (2),
- placing a mask (5) at the contour of the pattern to be created on the photosensitive resin (4),
- illuminating the resin (4) through the mask (5),
- removing the illuminated portions of the resin (4), if the photosensitive resin is of the positive type, or removing the non-illuminated portions of the resin (4), if the photosensitive resin is of the negative type,
- filling the removed portions (4a) of the resin (4) with at least one solder paste or powder (6) to produce partitions or a mould,
- heating the assembly formed of the base substrate (2), the resin (4) and the solder paste or powder (6) to melt the solder paste or powder (6) prior to solidification of the solder,
- removing all the resin (4), and
- filling the mould or decorative partitions (6) with at least one filler material (7) to obtain the decorated element (1).

2. Method for producing a decorated element (1) for a timepiece or piece of jewellery, the method includes the steps of:
- taking a ceramic base substrate (2),
- depositing a layer of positive or negative photosensitive resin (4) on the base substrate (2),
- placing a mask (5) at the contour of the pattern to be created on the photosensitive resin (4),
- illuminating the resin (4) through the mask (5),
- removing the illuminated portions of the resin (4), if the photosensitive resin is of the positive type, or removing the non-illuminated portions of the resin (4), if the photosensitive resin is of the negative type,
- depositing in the removed portions (4a) of the resin (4), one or more metal layers by physical vapour deposition or chemical vapour deposition,
- removing all the resin (4),
- depositing at least one solder paste or powder (6) on the metal layer or layers,
- melting the solder paste or powder (6) to obtain a solder liquid, which only wets the metal layer or layers, and solidifying the liquid solder to form partitions or a mould in the desired pattern, and
- filling the mould or decorative partitions (6) with at least one filler material (7) to obtain the decorated element (1).

3. Method for producing a decorated element (1) for a timepiece or piece of jewellery, the method includes the steps of:
- taking a metal base substrate (2),
- depositing a layer of positive or negative photosensitive resin (4) on the base substrate (2),
- placing a mask (5) at the contour of the pattern to be created on the photosensitive resin (4),
- illuminating the resin (4) through the mask (5),
- removing the illuminated portions of the resin (4), if the photosensitive resin is of the positive type, or removing the non-illuminated portions of the resin (4), if the photosensitive resin is of the negative type,
- depositing in the removed portions (4a) of the resin (4), one or more non-conductive layers by physical vapour deposition or chemical vapour deposition to define a complementary pattern for the creation of partitions or a mould,
- removing all the resin (4),
- depositing at least one solder paste or powder (6) on the base substrate,
- melting and solidifying the solder paste or powder (6) to form the partitions or the mould between the portions of the non-conductive layers, and
- filling the mould or decorative partitions (6) with at least one filler material (7) to obtain the decorated element (1).

4. Method for producing a decorated element (1) according to any of claims 1 to 3, **characterised in that** at least one conductive layer, such as a metal layer, is deposited by a physical vapour deposition or chemical vapour deposition or by cathodic sputtering on the surface of the base substrate (2) before the resin layer (4) is deposited.

5. Method for producing a decorated element (1) according to any of claims 1 to 3, **characterised in that** the solder paste or powder (6) used is metal solder paste or powder.

6. Method for producing a decorated element (1) according to claim 5, **characterised in that** the solder paste or powder (6) used is low temperature solder paste or powder below 380°C.

7. Method for producing a decorated element (1) according to claim 6, **characterised in that** the metal powder or powders (6) are formed of a mixture of gold and tin, or a mixture of gold and tin in a first powder and gold in a second powder.

8. Method for producing a decorated element (1) according to any of claims 1 to 3, **characterised in that** the solder paste or powder (6) is formed of eutectic compositions of Au-Si or Au-Ge or Au-Sb or Au-Ga or Au-Ga-In alloys.

9. Method for producing a decorated element (1) according to any of claims 1 to 3, **characterised in that** the solder paste or powder (6) used includes a mixture of metal powder and ceramic particles.

10. Method for producing a decorated element (1) according to any of claims 1 to 3, **characterised in that** the solder paste (6) is formed of at least one metal powder with at least one organic additive or binder.

11. Method for producing a decorated element (1) according to any of claims 1 to 3, **characterised in that** once the mould or decorative partitions (6) are filled with the solidified filler material (7) held to walls of said mould or of said partitions, a machining or selective dissolution operation is performed to remove the base substrate (2), which is metal or ceramic or ceramo-metallic or made of semiconductor material.

12. Method for producing a decorated element (1) according to any of claims 1 to 3, **characterised in that** the base substrate (2) is hollowed at the surface to improve the mechanical adherence of the filler material (7) on the hollowed surface of the substrate between the partitions (6).

13. Method for producing a decorated element (1) according to any of claims 1 to 3, **characterised in that** micro holes or hollows are made in the *cloisons* or the mould (6) to improve the mechanical adherence of the filler material (7).

14. Method for producing a decorated element (1) according to any of claims 1 to 3, wherein the decorated element (1) is a watch dial, **characterised in that** the mould or the decorative partitions (6) are filled with the filler material (7), which is cold enamel, such as epoxy resin, to obtain the decorated element (1).

15. Method for producing a decorated element (1) according to claim 14, **characterised in that** the mould or the decorative *cloisons* (6) are filled with the filler material (7), which is a thermos-hardening polymer containing colour pigments, and of a different colour from one partition to another.
